# EUROPÄISCHE PATENTSCHRIFT

(11) **EP 3 625 863 B1**
(45) Veröffentlichungstag und Bekanntmachung des Hinweises auf die Patenterteilung: **28.07.2021**
(21) Anmeldenummer: 18739784.9
(22) Anmeldetag: 29.06.2018
(51) Int. Cl.: H02H 3/16, H02H 7/122, H02H 7/26, G01R 31/08, H02J 3/00, H02H 3/04, H02H 3/08, H02M 5/40

(54) **ORTEN EINES ERDSCHLUSSES IN EINEM IT-NETZ**
LOCALISATION OF AN EARTH FAULT IN AN IT NETWORK
LOCALISATION D'UN DÉFAUT DE TERRE DANS UN RÉSEAU IT

(30) Priorität: 27.07.2017 EP 17183436
(43) Veröffentlichungstag der Anmeldung: 25.03.2020
(73) Patentinhaber: Siemens Aktiengesellschaft, 80333 München (DE)
(72) Erfinder: WEIS, Benno, 91334 Hemhofen (DE)
(86) Internationale Anmeldenummer: PCT/EP2018/067617
(87) Internationale Veröffentlichungsnummer: WO 2019/020316

(56) Entgegenhaltungen:
- EP-A2- 2 439 827
- WO-A1-2017/032992
- DE-A1-102010 030 079
- US-A1- 2008 084 215
- US-A1- 2013 170 077
- US-A1- 2017 131 340

## Beschreibung

Die Erfindung betrifft das Orten eines Erdschlusses in einem IT-Netz, das ein Stromübertragungsnetz, eine rotierende elektrische Maschine und einen Stromrichter, der eingangsseitig an das Stromübertragungsnetz und ausgangsseitig an die rotierende elektrische Maschine angeschlossen ist, aufweist.

In IT-Netzen zur elektrischen Stromversorgung ist es grundsätzlich zulässig, das IT-Netz im Falle eines einfachen Erdschlusses weiter zu betreiben. In IT-Netzen, die rotierende elektrische Maschinen aufweisen, die jeweils über einen Stromrichter an ein Stromübertragungsnetz des IT-Netzes angeschlossen sind, gilt dies auch für den Fall, dass der Erdschluss in dem Stromübertragungsnetz auftritt. In diesem Fall erhöht sich lediglich die grundfrequente Gleichtaktspannung aller angeschlossenen Verbraucher.

Tritt der Erdschluss jedoch in einem Maschinenbereich des IT-Netzes auf, der eine rotierende elektrische Maschine und eine Verbindungsleitung zwischen der elektrischen Maschine und dem zugehörigen Stromrichter aufweist, so werden das gesamte IT-Netz und damit auch alle angeschlossenen Verbraucher mit der pulsfrequenten Ausgangsspannung dieses Stromrichters beaufschlagt. Dies kann dazu führen, dass Verbraucher an dem IT-Netz überlastet werden. Zudem ist es möglich, dass die elektromagnetische Abstrahlung des IT-Netzes unzulässig hoch wird und benachbarte elektrische Geräte stört. Diese Problematik existiert sowohl in Wechselstrom-IT-Netzen als auch in Gleichstrom-IT-Netzen.

Üblicherweise wird ein Erdschluss, der in einem Maschinenbereich eines IT-Netzes auftritt, durch einen Isolationswächter erkannt, der detektiert, ob ein unzulässiger Gleichtaktstrom fließt. Alternativ kann der Erdschluss auch dadurch erkannt werden, dass eine Netzspannung des IT-Netzes gegenüber einem Erdpotential überwacht wird, und auf einen Erdschluss in einem Maschinenbereich eines IT-Netzes wird geschlossen, wenn die Netzspannung pulsfrequente Anteile enthält. Mit keinem dieser Verfahren kann jedoch festgestellt werden, in welchem Maschinenbereich des IT-Netzes der Erdschluss auftritt. Deshalb werden in der Regel alle Verbraucher an dem IT-Netz abgeschaltet, wenn erkannt wird, dass ein Erdschluss in einem Maschinenbereich auftritt.

EP 2439827 A2 offenbart ein Verfahren zum Erkennen eines Erdschlusses in einem hochohmigen Stromnetz, das einen Gleichrichter, einen Wechselrichter und einen den Gleichrichter und den Wechselrichter verbindenden Gleichspannungszwischenkreis aufweist. Dabei wird eine Spannung zwischen einem Potential des Gleichspannungszwischenkreises und einem Erdpotential erfasst und zum Erkennen des Erdschlusses verwendet.

US 2017/131340 A1 offenbart ein Fehlererkennungssystem zum Erkennen von Erdschlüssen in einem Stromrichtersystem. Das Fehlererkennungssystem umfasst eine Erfassungsvorrichtung mit einem Kopplungskondensator, der mit einem Gleichspannungszwischenkreis des Stromrichtersystems verbunden ist, um eine zeitvariable Spannung zu erfassen, die eine Streuflussverbindung anzeigt.

WO 2017/032992 A1 offenbart ein Energieverteilungssystem mit einer Vielzahl von Stromrichtersystemen. Um den Ort eines Erdschlusses in dem Energieverteilungssystem zu bestimmen, werden Frequenzspektren von Nullsystemströmen der Stromrichtersysteme ausgewertet.

US 2008/084215 A1 offenbart ein Verfahren zur Isolationsüberwachung in einer Umrichteranwendung, wobei Isolationsdefekte durch den Vergleich in einer Testkonfiguration gemessener Spannungen oder daraus abgeleiteter Größen mit Referenzwerten bestimmt werden.

US 2013/170077 A1 offenbart ein Verfahren zum Betreiben eines Fehlerstromschutzschalters für einen Frequenzumrichter. Dabei wird ein Signal zu einem Gleichtaktstrom in einer Netzleitungseinrichtung erfasst, über welche der Frequenzumrichter einen Netzstrom empfängt. Um einen Fehlerstrom zu erkennen, wird das erfasste Signal mit einem erwarteten Signal verglichen, das aus einer Schaltinformation über Schaltvorgänge in dem Frequenzumrichter ermittelt wird.

DE 102010030079 A1 offenbart ein Verfahren und eine Vorrichtung zur Überwachung des Isolationswiderstandes in einem ungeerdeten elektrischen Netz mit einem Gleichspannungszwischenkreis und mindestens einem daran angeschlossenen Wechselrichter zur Steuerung eines elektrischen Verbrauchers. Dabei wird während des Betriebs des Verbrauchers eine zu überwachende Spannung bestimmt, welche eine Spannungsschwankung von Versorgungsspannungspotentialen des Gleichspannungszwischenkreises gegen ein Bezugspotential repräsentiert. Um einen Isolationsfehler zu detektieren, wird eine Spektralamplitude der zu überwachenden Spannung mit einem Referenzwert verglichen.

Der Erfindung liegt die Aufgabe zugrunde, ein verbessertes Verfahren zum Orten eines Erdschlusses in einem IT-Netz anzugeben, das insbesondere die Identifizierung desjenigen Maschinenbereichs, in dem ein Erdschluss auftritt, ermöglicht.

Die Aufgabe wird erfindungsgemäß durch ein Verfahren mit den Merkmalen des Anspruchs 1 gelöst.

Vorteilhafte Ausgestaltungen der Erfindung sind Gegenstand der Unteransprüche.

Das erfindungsgemäße Verfahren dient dem Orten eines Erdschlusses in einem IT-Netz, das ein Stromübertragungsnetz, eine rotierende elektrische Maschine und einen Stromrichter aufweist, wobei der Stromrichter eingangsseitig an das Stromübertragungsnetz und ausgangsseitig an die rotierende elektrische Maschine angeschlossen ist und einen Gleichspannungszwischenkreis und einen mit dem Gleichspannungszwischenkreis und der elektrischen Maschine verbundenen Wechselrichter aufweist. Bei den Verfahren wird eine Gleichtaktspannungseigenschaft einer Gleichtaktspannung des Stromrichters oder des Stromübertragungsnetzes erfasst, die Gleichtaktspannungseigenschaft wird mit einer Ausgangsspannungseigenschaft einer Ausgangsspannung des Wechselrichters verglichen, und im Falle eines Erdschlusses in dem IT-Netz wird anhand des Vergleiches der Gleichtaktspannungseigenschaft mit der Ausgangsspannungseigenschaft darauf geschlossen, ob ein dem Stromrichter nachgeschalteter Maschinenbereich des IT-Netzes, der die elektrische Maschine und eine Verbindungsleitung zwischen der elektrischen Maschine und dem Stromrichter aufweist, die Ursache des Erdschlusses ist.

Unter einem Wechselrichter wird hier und im Folgenden stets ein Wechselrichter verstanden, der pulsweitenmoduliert angesteuerte elektronische Schalteinheiten aufweist.

Die Erfindung nutzt aus, dass im Falle eines Erdschlusses in einem Maschinenbereich des IT-Netzes die Ausgangsspannung des mit dem Maschinenbereich verbundenen Wechselrichters die Gleichtaktspannungen des den Wechselrichter aufweisenden Stromrichters und des Stromübertragungsnetzes beeinflusst. Daher kann durch den Vergleich einer Ausgangsspannungseigenschaft einer Ausgangsspannung des Wechselrichters mit einer dazu korrespondierenden Gleichtaktspannungseigenschaft einer Gleichtaktspannung des Stromrichters oder des Stromübertragungsnetzes ermittelt werden, ob in dem mit diesem Wechselrichter verbundenen Maschinenbereich ein Erdschluss auftritt.

Indem alle Stromrichter des IT-Netzes, die jeweils mit einem Maschinenbereich verbunden sind, auf diese Weise überwacht werden, kann festgestellt werden, in welchem dieser Maschinenbereiche ein Erdschluss auftritt. Dies ermöglicht insbesondere, gezielt denjenigen Maschinenbereich abzuschalten, in dem ein Erdschluss auftritt, so dass das IT-Netz im Falle eines Erdschlusses in einem Maschinenbereich weiter betrieben werden kann. Die erfindungsgemäßen Verfahren sind daher besonders vorteilhaft in IT-Netzen, die mehrere rotierende elektrische Maschinen aufweisen, die jeweils gemäß Anspruch 1 über einen Stromrichter mit dem Stromübertragungsnetz des IT-Netzes verbunden sind. Die Formulierung des Anspruchs 1, dass das IT-Netz eine rotierende elektrische Maschine und einen mit ihr verbundenen Stromrichter aufweist, ist daher nicht in dem Sinne zu verstehen, dass das IT-Netz nur eine rotierende elektrische Maschine und einen mit ihr verbundenen Stromrichter aufweist, sondern dass das IT-Netz wenigstens eine rotierende elektrische Maschine aufweist, die gemäß Anspruch 1 über einen Stromrichter mit dem Stromübertragungsnetz des IT-Netzes verbunden ist.

Das erfindungsgemäße Verfahren kann insbesondere mit einem geringen Aufwand und daher kostengünstig realisiert werden, da zu dessen Ausführung kein Bauteil oder Gerät erforderlich ist, das in dem Leistungspfad einer rotierenden elektrischen Maschine liegt.

Das erfindungsgemäße Verfahren sieht vor, dass als Gleichtaktspannungseigenschaft Spannungsimpulse entweder einer Spannung zwischen einem Zwischenkreispotential des Gleichspannungszwischenkreises des Stromrichters und einem Erdpotential oder einer Netzspannung des Stromübertragungsnetzes gegenüber dem Erdpotential erfasst werden, als Ausgangsspannungseigenschaft Schalthandlungen einer Phase des Wechselrichters verwendet werden und auf den Maschinenbereich als Ursache des Erdschlusses geschlossen wird, wenn die Spannungsimpulse zeitgleich mit den Schalthandlungen erfolgen.

Dieses Verfahren nutzt aus, dass im Falle eines Erdschlusses in einem Maschinenbereich des IT-Netzes die Spannung an dem Gleichspannungszwischenkreis des mit diesem Maschinenbereich verbundenen Stromrichters und die Netzspannung des Stromübertragungsnetzes des IT-Netzes (jeweils gegenüber dem Erdpotential) mit der pulsfrequenten Ausgangsspannung des Wechselrichters dieses Stromrichters beaufschlagt werden. Daher kann ein Erdschluss in einem Maschinenbereich des IT-Netzes durch eine zeitliche Übereinstimmung von Spannungsimpulsen der Spannung an dem Gleichspannungszwischenkreis oder der Netzspannung mit den Schalthandlungen einer Phase des mit dem Maschinenbereich verbundenen Wechselrichters erkannt werden.

Eine Ausgestaltung des Verfahrens sieht vor, dass eine Schwellenzeitdauer vorgegeben wird und ein Spannungsimpuls als zeitgleich mit einer Schalthandlung definiert wird, wenn ein zeitlicher Abstand zwischen dem Spannungsimpuls und der Schalthandlung kleiner als die Schwellenzeitdauer ist. Beispielsweise wird eine Schwellenzeitdauer vorgegeben, die kleiner als 10 µs ist.

Diese Ausgestaltung berücksichtigt, dass die Spannungsimpulse zeitlich etwas verzögert auf die Schalthandlungen folgen. Ferner können durch die Schwellenzeitdauer Messfehler bei der Bestimmung der zeitlichen Korrelation der Spannungsimpulse und Schalthandlungen kompensiert werden.

Das Verfahren sieht ferner vor, dass eine Zähldauer, beispielsweise etwa eine Sekunde, und ein Anzahlschwellenwert, beispielsweise etwa 1000, vorgegeben werden und innerhalb der Zähldauer eine Bewertungsanzahl von zeitgleichen Spannungsimpulsen und Schalthandlungen erfasst wird, und dass auf den Maschinenbereich als Ursache des Erdschlusses geschlossen wird, wenn die Bewertungsanzahl den Anzahlschwellenwert überschreitet.

Dieser Aspekt des Verfahrens berücksichtigt, dass die Schalthandlungen pulsförmig sind und daher von den Schalthandlungen verursachte Spannungsimpulse ebenfalls pulsförmig sind. Ein Erdschluss in einem Maschinenbereich verursacht daher eine Vielzahl von in kurzen zeitlichen Abständen aufeinander folgenden Spannungsimpulsen, die zeitlich zu den Schalthandlungen des mit dem Maschinenbereich verbundenen Wechselrichters korreliert sind. Auf den Maschinenbereich als Ursache des Erdschlusses kann daher besonders zuverlässig geschlossen wird, wenn die Pulsmuster der Spannungsimpulse und der Schalthandlungen weitgehend übereinstimmen. Eine derartige Übereinstimmung wird durch den Anzahlschwellenwert für innerhalb der Zähldauer gleichzeitig erfolgende Spannungsimpulse und Schalthandlungen quantifiziert.

Weitere Ausgestaltungen des Verfahrens sehen vor, dass die Schalthandlungen einer Phase des Wechselrichters entweder durch eine Messung der Ausgangsspannung der Phase gegen ein Zwischenkreispotential des Gleichspannungszwischenkreises erfasst oder aus Ansteuersignalen zur Ansteuerung der Phase ermittelt werden.

Bei diesen Ausgestaltungen werden die Schalthandlungen einer Phase des Wechselrichters also entweder aus einer Messung der Ausgangsspannung der Phase oder aus Ansteuersignalen zur Ansteuerung der Phase ermittelt. Die Erfassung der Schalthandlungen durch eine Messung der Ausgangsspannung ermöglicht eine zuverlässige Bestimmung der tatsächlich erfolgenden Schalthandlungen. Die Ermittlung der Schalthandlungen aus den Ansteuersignalen hat demgegenüber den Vorteil, dass die Ausgangsspannung der Phase nicht gemessen werden muss.

Ein anderes Verfahren, dass nicht im Umfang der beanspruchten Erfindung liegt, kann vorsehen, dass als Gleichtaktspannungseigenschaft ein Frequenzspektrum einer Netzspannung des Stromübertragungsnetzes gegenüber einem Erdpotential erfasst wird, als Ausgangsspannungseigenschaft eine Ausgangsgrundfrequenz der Ausgangsspannung des Wechselrichters verwendet wird und auf den Maschinenbereich als Ursache des Erdschlusses geschlossen wird, wenn das Frequenzspektrum der Netzspannung einen mit der Ausgangsgrundfrequenz übereinstimmenden Spektralanteil aufweist. Im Falle eines mehrphasigen Stromübertragungsnetzes wird als Netzspannung beispielsweise eine Phasenspannung oder die Summe aller Phasenspannungen des Stromübertragungsnetzes gegenüber einem Erdpotential verwendet.

Dieses andere Verfahren nutzt aus, dass im Falle eines Erdschlusses in einem Maschinenbereich des IT-Netzes die Ausgangsgrundfrequenz der Ausgangsspannung des Wechselrichters in das Stromübertragungsnetz des IT-Netzes übertragen wird, so dass die Phasenspannungen des Stromübertragungsnetzes gegen ein Erdpotential nicht nur einen Spektralanteil bei ihrer Betriebsfrequenz (z.B. 50 Hz oder 60 Hz) enthalten, sondern auch einen Spektralanteil bei der Ausgangsgrundfrequenz des erdschlussbehafteten Maschinenbereiches. Daher kann ein Erdschluss in einem Maschinenbereich des IT-Netzes auch dadurch erkannt werden, dass das Frequenzspektrum der Netzspannung des Stromübertragungsnetzes einen Spektralanteil aufweist, der mit der Ausgangsgrundfrequenz der Ausgangsspannung des mit dem Maschinenbereich verbundenen Wechselrichters übereinstimmt.

Das andere Verfahren kann weiterhin vorsehen, dass als Ausgangsgrundfrequenz eine Sollgrundfrequenz der Ausgangsspannung des Wechselrichters verwendet wird, oder dass die Ausgangsgrundfrequenz gemessen wird.

Die Messung der Ausgangsgrundfrequenz ermöglicht eine zuverlässige Bestimmung der Ausgangsgrundfrequenz. Demgegenüber hat die Verwendung einer Sollgrundfrequenz der Ausgangsspannung des Wechselrichters als Ausgangsgrundfrequenz den Vorteil, dass die Ausgangsgrundfrequenz nicht gemessen werden muss.

Ebenfalls kann das andere Verfahrens vorsehen, dass als Gleichtaktspannungseigenschaft ein Frequenzspektrum einer Netzspannung des Stromübertragungsnetzes gegenüber einem Erdpotential erfasst wird, als Ausgangsspannungseigenschaft eine Schaltfrequenz der Ausgangsspannung des Wechselrichters verwendet wird und auf den Maschinenbereich als Ursache des Erdschlusses geschlossen wird, wenn das Frequenzspektrum der Netzspannung einen mit der Schaltfrequenz der Ausgangsspannung des Wechselrichters übereinstimmenden Spektralanteil aufweist.

So wird auf einen Maschinenbereich als Ursache des Erdschlusses geschlossen, wenn das Frequenzspektrum der Netzspannung sowohl einen Spektralanteil bei der Sollgrundfrequenz der Ausgangsspannung als auch einen Spektralanteil bei der Schaltfrequenz des Stromrichters enthält. Diese Auswertung des Frequenzspektrums bietet den Vorteil, dass ein Maschinenbereich auch dann eindeutig als Ursache des Erdschlusses identifiziert werden kann, wenn die Ausgangsspannungen zweier Stromrichter identische Sollgrundfrequenzen, aber unterschiedliche Schaltfrequenzen oder identische Schaltfrequenzen, aber unterschiedliche Sollgrundfrequenzen aufweisen.

Weitere Ausgestaltungen des Verfahrens sehen vor, dass eine Steuerungseinheit des Stromrichters die Ansteuerung des Stromrichters sperrt oder eine übergeordnete Netzsteuerungseinheit des IT-Netzes den Stromrichter sperrt, wenn auf den Maschinenbereich als Ursache des Erdschlusses geschlossen wird.

Diese Ausgestaltungen ermöglichen, einen Maschinenbereich durch die Steuerungseinheit des zugehörigen Stromrichters oder durch Sperrung des zugehörigen Stromrichters mittels einer übergeordneten Netzsteuerungseinheit des IT-Netzes abzuschalten, wenn auf den Maschinenbereich als Ursache des Erdschlusses geschlossen wird.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit einer Zeichnung näher erläutert wird.

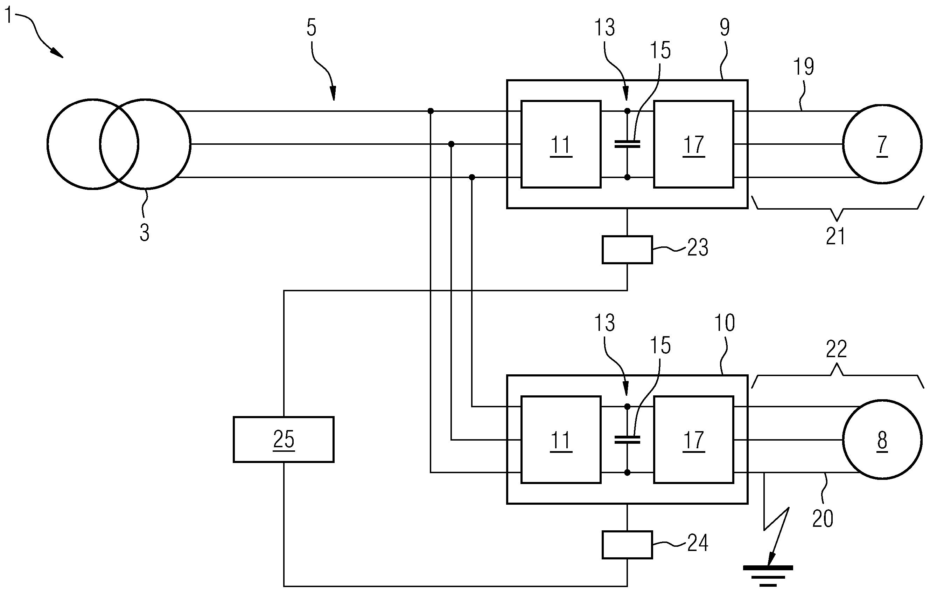

Dabei zeigt die einzige Figur schematisch ein IT-Netz 1 mit einer Stromquelle 3, einem Stromübertragungsnetz 5 und zwei rotierenden elektrischen Maschinen 7, 8, die jeweils über einen Stromrichter 9, 10 an das Stromübertragungsnetz 5 angeschlossen sind.

Das Stromübertragungsnetz 5 des in der Figur dargestellten IT-Netzes 1 ist ein dreiphasiges Wechselstromnetz. Jede elektrische Maschine 7, 8 ist beispielsweise ein dreiphasiger Elektromotor.

Jeder Stromrichter 9, 10 ist eingangsseitig an das Stromübertragungsnetz 5 und ausgangsseitig an eine elektrische Maschine 7, 8 angeschlossen. Ferner ist jeder Stromrichter 9, 10 als ein Umrichter ausgeführt, der einen eingangsseitigen Dreiphasengleichrichter 11, einen Gleichspannungszwischenkreis 13 mit einem Zwischenkreiskondensator 15 und einen ausgangsseitigen Wechselrichter 17 aufweist. Der Dreiphasengleichrichter 11 ist mit dem Stromübertragungsnetz 5 und dem Gleichspannungszwischenkreis 13 verbunden. Der Wechselrichter 17 ist mit dem Gleichspannungszwischenkreis 13 und der jeweiligen elektrischen Maschine 7, 8 verbunden.

Eine erste elektrische Maschine 7 ist über erste Verbindungsleitungen 19 mit einem ersten Stromrichter 9 verbunden. Die erste elektrische Maschine 7 und die ersten Verbindungsleitungen 19 definieren einen ersten Maschinenbereich 21 des IT-Netzes 1.

Die zweite elektrische Maschine 8 ist über zweite Verbindungsleitungen 20 mit dem zweiten Stromrichter 10 verbunden. Die zweite elektrische Maschine 8 und die zweiten Verbindungsleitungen 20 definieren einen zweiten Maschinenbereich 22 des IT-Netzes 1.

Das erfindungsgemäße Verfahren dient dazu, einen Erdschluss in einem Maschinenbereich 21, 22 zu erkennen und zu detektieren, in welchem Maschinenbereich 21, 22 der Erdschluss auftritt, um diesen Maschinenbereich 21, 22 gezielt abzuschalten und so das restliche IT-Netz 1 weiter betreiben zu können. In der Figur ist ein Erdschluss in dem zweiten Maschinenbereich 22 durch ein Blitzsymbol angedeutet.

Ein erstes Ausführungsbeispiel des erfindungsgemäßen Verfahrens sieht vor, dass für jeden Stromrichter 9, 10 Spannungsimpulse einer Spannung zwischen einem Zwischenkreispotential des Gleichspannungszwischenkreises 13 und einem Erdpotential erfasst und mit Schalthandlungen einer Phase des Wechselrichters 17 des jeweiligen Stromrichters 9, 10 verglichen werden. Wenn für einen der Stromrichter 9, 10 die erfassten Spannungsimpulse zeitgleich mit den Schalthandlungen erfolgen, wird auf den mit diesem Stromrichter 9, 10 verbundenen Maschinenbereich 21, 22 als Ursache eines Erdschlusses geschlossen.

Dabei wird beispielsweise eine Schwellenzeitdauer vorgegeben und ein Spannungsimpuls wird als zeitgleich mit einer Schalthandlung definiert, wenn ein zeitlicher Abstand zwischen dem Spannungsimpuls und der Schalthandlung kleiner als die Schwellenzeitdauer ist. Beispielsweise wird eine Schwellenzeitdauer vorgegeben, die kleiner als 10 µs ist.

Ferner werden eine Zähldauer, beispielsweise etwa eine Sekunde, und ein Anzahlschwellenwert, beispielsweise etwa 1000, vorgegeben und innerhalb der Zähldauer wird eine Bewertungsanzahl von zeitgleichen Spannungsimpulsen und Schalthandlungen erfasst. Auf einen Maschinenbereich 21, 22 als Ursache eines Erdschlusses wird nur dann geschlossen, wenn für den mit diesem Maschinenbereich 21, 22 verbundenen Stromrichter 9, 10 die Bewertungsanzahl den Anzahlschwellenwert überschreitet.

Die Schalthandlungen einer Phase des Wechselrichters 17 eines Stromrichters 9, 10 werden beispielsweise durch eine Messung der Ausgangsspannung der Phase gegen ein Zwischenkreispotential des Gleichspannungszwischenkreises des Stromrichters 9, 10 erfasst oder aus Ansteuersignalen zur Ansteuerung der Phase ermittelt.

Ein zweites Ausführungsbeispiel des erfindungsgemäßen Verfahrens unterscheidet sich von dem ersten Ausführungsbeispiel im Wesentlichen nur dadurch, dass anstelle von Spannungsimpulsen der Spannungen an den Gleichspannungszwischenkreisen 13 der Stromrichter 9, 10 Spannungsimpulse einer Netzspannung des Stromübertragungsnetzes gegenüber einem Erdpotential erfasst und jeweils mit Schalthandlungen einer Phase des Wechselrichters 17 jedes Stromrichters 9, 10 verglichen werden. Wenn für einen der Stromrichter 9, 10 die erfassten Spannungsimpulse zeitgleich mit den Schalthandlungen erfolgen, wird auf den mit diesem Stromrichter 9, 10 verbundenen Maschinenbereich 21, 22 als Ursache eines Erdschlusses geschlossen. Ausgestaltungen dieses Ausführungsbeispiels hinsichtlich der Definition und Erkennung zeitgleicher Spannungsimpulse und Schalthandlungen sowie der Ermittlung der Schalthandlungen einer Phase eines Wechselrichters 17 entsprechen den oben genannten Ausgestaltungen des ersten Ausführungsbeispiels.

Bei einem anderen Verfahren, dass nicht im Umfang der beanspruchten Erfindung liegt, wird ein Frequenzspektrum einer Netzspannung des Stromübertragungsnetzes gegenüber einem Erdpotential erfasst und mit der Ausgangsgrundfrequenz und/oder der Schaltfrequenz der Ausgangsspannung des Wechselrichters 17 jedes Stromrichters 9, 10 verglichen. Wenn die Ausgangsspannungen der Wechselrichter 17 der Stromrichter 9, 10 unterschiedliche Ausgangsgrundfrequenzen aufweisen, wird auf einen Maschinenbereich 21, 22 als Ursache eines Erdschlusses geschlossen, wenn das erfasste Frequenzspektrum einen Spektralanteil aufweist, der mit der Ausgangsgrundfrequenz der Ausgangsspannung des Wechselrichters 17 desjenigen Stromrichters 9, 10 übereinstimmt, der mit diesem Maschinenbereich 21, 22 verbunden ist. Wenn die Ausgangsspannungen der Wechselrichter 17 der Stromrichter 9, 10 gleiche Ausgangsgrundfrequenzen aber unterschiedliche Schaltfrequenzen aufweisen, wird auf einen Maschinenbereich 21, 22 als Ursache eines Erdschlusses geschlossen, wenn das erfasste Frequenzspektrum einen Spektralanteil aufweist, der mit der Schaltfrequenz der Ausgangsspannung des Wechselrichters 17 desjenigen Stromrichters 9, 10 übereinstimmt, der mit diesem Maschinenbereich 21, 22 verbunden ist.

In dem in der Figur dargestellten Fall eines mehrphasigen Stromübertragungsnetzes 5 wird als Netzspannung beispielsweise eine Phasenspannung oder die Summe aller Phasenspannungen des Stromübertragungsnetzes 5 gegenüber einem Erdpotential verwendet.

Als Ausgangsgrundfrequenz der Ausgangsspannung eines Wechselrichters 17 wird beispielsweise eine Sollgrundfrequenz der Ausgangsspannung des Wechselrichters 17 verwendet oder die Ausgangsgrundfrequenz wird gemessen.

In allen oben genannten Ausführungsbeispielen wird ein Maschinenbereich 21, 22, in dem ein Erdschluss erkannt wird, beispielsweise abgeschaltet, indem eine Steuerungseinheit 23, 24 des mit diesem Maschinenbereich 21, 22 verbundenen Stromrichters 9, 10 die Ansteuerung des Stromrichters 9, 10 sperrt, oder indem eine übergeordnete Netzsteuerungseinheit 25 des IT-Netzes 1 den mit diesem Maschinenbereich 21, 22 verbundenen Stromrichter 9, 10 sperrt.

Alle oben genannten Ausführungsbeispiele können analog auch für ein IT-Netz 1 angewendet werden, dessen Stromübertragungsnetz 5 ein Gleichstromnetz ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Orten eines Erdschlusses in einem IT-Netz (1), das ein Stromübertragungsnetz (5), eine rotierende elektrische Maschine (7, 8) und einen Stromrichter (9, 10) aufweist, wobei der Stromrichter (9, 10) eingangsseitig an das Stromübertragungsnetz (5) und ausgangsseitig an die elektrische Maschine (7, 8) angeschlossen ist und einen Gleichspannungszwischenkreis (13) und einen mit dem Gleichspannungszwischenkreis (13) und der elektrischen Maschine (7, 8) verbundenen Wechselrichter (17) aufweist, wobei
- Spannungsimpulse einer Spannung zwischen einem Zwischenkreispotential des Gleichspannungszwischenkreises (13) und einem Erdpotential oder Spannungsimpulse einer Netzspannung des Stromübertragungsnetzes (5) gegenüber einem Erdpotential erfasst werden,
- die Spannungsimpulse mit Schalthandlungen einer Phase des Wechselrichters (17) verglichen werden,
**dadurch gekennzeichnet, dass**
- eine Zähldauer und ein Anzahlschwellenwert vorgegeben werden und innerhalb der Zähldauer eine Bewertungsanzahl von zeitgleichen Spannungsimpulsen und Schalthandlungen erfasst wird,
- und im Falle eines Erdschlusses in dem IT-Netz (1) darauf geschlossen wird, dass ein dem Stromrichter (9, 10) nachgeschalteter Maschinenbereich (21, 22) des IT-Netzes (1), der die elektrische Maschine (7, 8) und eine Verbindungsleitung (19, 20) zwischen der elektrischen Maschine (7, 8) und dem Stromrichter (9, 10) aufweist, die Ursache des Erdschlusses ist, wenn die Bewertungsanzahl den Anzahlschwellenwert überschreitet.

2. Verfahren nach Anspruch 1,
**dadurch gekennzeichnet, dass** eine Schwellenzeitdauer vorgegeben wird und ein Spannungsimpuls als zeitgleich mit einer Schalthandlung definiert wird, wenn ein zeitlicher Abstand zwischen dem Spannungsimpuls und der Schalthandlung kleiner als die Schwellenzeitdauer ist.

3. Verfahren nach Anspruch 2,
**dadurch gekennzeichnet, dass** eine Schwellenzeitdauer vorgegeben wird, die kleiner als 10 µs ist.

4. Verfahren nach einem der vorhergehenden Ansprüche,
**dadurch gekennzeichnet, dass** die Schalthandlungen einer Phase des Wechselrichters (17) durch eine Messung einer Ausgangsspannung der Phase gegen ein Zwischenkreispotential des Gleichspannungszwischenkreises (13) erfasst werden.

5. Verfahren nach einem der Ansprüche 1 bis 3,
**dadurch gekennzeichnet, dass** die Schalthandlungen einer Phase des Wechselrichters (17) aus Ansteuersignalen zur Ansteuerung der Phase ermittelt werden.

6. Verfahren nach einem der vorhergehenden Ansprüche,
**dadurch gekennzeichnet, dass** eine Steuerungseinheit (23, 24) des Stromrichters (9, 10) die Ansteuerung des Stromrichters (9, 10) sperrt, wenn auf den Maschinenbereich (21, 22) als Ursache des Erdschlusses geschlossen wird.

7. Verfahren nach einem der Ansprüche 1 bis 5,
**dadurch gekennzeichnet, dass** eine übergeordnete Netzsteuerungseinheit (25) des IT-Netzes (1) den Stromrichter (9, 10) sperrt, wenn auf den Maschinenbereich (21, 22) als Ursache des Erdschlusses geschlossen wird.

## Claims

1. Method for location of an earth fault in an IT network (1), which has a power transmission network (5), a rotating electrical machine (7, 8) and a converter (9, 10), wherein the converter (9, 10) is connected on its input side to the power transmission network (5) and on its output side to the electrical machine (7, 8) and has a DC link circuit (13) and an inverter (17) connected to the DC link circuit (13) and the electrical machine (7, 8), wherein
- voltage pulses of a voltage between a DC link circuit potential of the DC link circuit (13) and an earth potential or voltage pulses of a network voltage of the power transmission network (5) in relation to an earth potential are acquired,
- the voltage pulses are compared with switching actions of a phase of the inverter (17),
**characterised in that**
- a count duration and a number threshold value are predetermined and within the count period an evaluation number of simultaneous voltage pulses and switching actions is acquired
- and in the event of an earth fault in the IT network (1), it is concluded that a machine area (21, 22) of the IT network (1) connected downstream of the converter (9, 10), which has the electrical machine (7, 8) and a connecting line (19, 20) between the electrical machine (7, 8) and the converter (9, 10) is the cause of the earth fault if the evaluation number exceeds the number threshold value.

2. Method according to claim 1,
**characterised in that** a threshold period is predetermined and a voltage pulse is defined as being at the same time as a switching action if a time gap between the voltage pulse and the switching action is less than the threshold period.

3. Method according to claim 2,
**characterised in that** a threshold period is predetermined that is less than 10 µs.

4. Method according to one of the preceding claims,
**characterised in that** the switching actions of a phase of the inverter (17) are acquired by a measurement of an output voltage of the phase against a DC link circuit potential of the DC link circuit (13).

5. Method according to one of claims 1 to 3,
**characterised in that** the switching actions of a phase of the inverter (17) are established as activation signals for activating the phase.

6. Method according to one of the preceding claims,
**characterised in that** a control unit (23, 24) of the converter (9, 10) blocks the activation of the converter (9, 10) if it is concluded that the machine area (21, 22) is the cause of the earth fault.

7. Method according to one of claims 1 to 5,
**characterised in that** a higher-ranking network control unit (25) of the IT network (1) blocks the converter (9, 10) if it is concluded that the machine area (21, 22) is the cause of the earth fault.

## Revendications

1. Procédé de localisation d'un défaut à la terre dans un réseau (1) IT, qui a un réseau (5) de transport de courant, une machine (7, 8) électrique tournante et un convertisseur (9, 10) de courant, le convertisseur (9, 10) de courant étant connecté du côté de l'entrée au réseau (5) de transport du courant et du côté de la sortie à la machine (7, 8) électrique et ayant un circuit (13) intermédiaire à tension continue et un onduleur (17) connecté au circuit (13) intermédiaire à tension continue et à la machine (7, 8) électrique, dans lequel
- on détecte des impulsions d'une tension entre un potentiel du circuit (13) intermédiaire à tension continue et un potentiel de terre ou des impulsions d'une tension du réseau (5) de transport de courant par rapport à un potentiel de terre,
- on compare les impulsions de tension à des manipulations de coupure d'une phase de l'onduleur (17),
**caractérisé en ce que**
- on prescrit une durée de dénombrement et une valeur de seuil de dénombrement et dans la durée de dénombrement, on détecte un nombre d'évaluation d'impulsions de tension et de manipulations de coupure en même temps,
- et, dans le cas d'un défaut à la terre dans le réseau (1) IT, on déduit qu'une partie (21, 22) de machine, montée en aval du convertisseur (9, 10) de courant, du réseau (1) IT, qui a la machine (7, 8) électrique et une ligne (19, 20) de liaison entre la machine (7, 8) électrique et le convertisseur (9, 10), est la cause du défaut à la terre si le nombre d'évaluation dépasse la valeur de seuil de dénombrement.

2. Procédé suivant la revendication 1,
**caractérisé en ce que** l'on prescrit une durée de seuil et on définit une impulsion de tension comme simultanée à une manipulation de coupure si une distance dans le temps entre l'impulsion de tension et la manipulation de coupure est plus petite que la durée de seuil.

3. Procédé suivant la revendication 2,
**caractérisé en ce que** l'on prescrit une durée de seuil, qui est plus petite que 10 µs.

4. Procédé suivant l'une des revendications précédentes,
**caractérisé en ce que** l'on détecte les manipulations de coupure d'une phase de l'onduleur (17) par une mesure d'une tension de sortie de la phase par rapport à un potentiel du circuit (13) intermédiaire à tension continue.

5. Procédé suivant l'une des revendications 1 à 3,
**caractérisé en ce que** l'on détermine les manipulations de coupure d'une phase de l'onduleur (17) à partir de signaux de commande de la phase.

6. Procédé suivant l'une des revendications précédentes,
**caractérisé en ce qu'**une unité (23, 24) de commande du convertisseur (9, 10) bloque la commande du convertisseur (9, 10), si l'on déduit que la partie (21, 22) de machine est la cause du défaut à la terre.

7. Procédé suivant l'une des revendications 1 à 5,
**caractérisé en ce qu'**une unité (25) supérieur hiérarchiquement de commande du réseau (1) IT bloque le convertisseur (9, 10), si l'on déduit que la partie (21, 22) de machine est la cause du défaut à la terre.
